# EUROPÄISCHE PATENTSCHRIFT

(11) **EP 2 169 733 B1**
(45) Veröffentlichungstag und Bekanntmachung des Hinweises auf die Patenterteilung: **19.07.2017**
(21) Anmeldenummer: 09180431.0
(22) Anmeldetag: 27.08.1998
(51) Int. Cl.: H01L 33/20, H01L 33/38, H01L 33/62

(54) **Halbleiterlichtquelle**
Semiconductor light source
Source lumineuse à semi-conducteur

(30) Priorität: 29.09.1997 DE 19742963
(43) Veröffentlichungstag der Anmeldung: 31.03.2010
(62) Teilanmeldung aus: 98116218.3
(73) Patentinhaber: OSRAM Opto Semiconductors GmbH, 93055 Regensburg (DE)
(72) Erfinder: Heinen, Jochen, 85540, Haar (DE)
(74) Vertreter: Epping - Hermann - Fischer

(56) Entgegenhaltungen:
- EP-A- 0 720 241
- GB-A- 2 019 643
- JP-A- 1 084 759
- JP-A- 8 116 090
- US-A- 5 153 889
- US-A- 5 557 115
- US-A- 5 578 162
- US-A- 5 652 438

## Beschreibung

Die Erfindung betrifft eine Halbleiterlichtquelle mit einem epitaktisch gewachsenen Schichtenstapel nach dem Oberbegriff des Anspruchs 1.

Beispiele für Lichtquellen der genannten Art sind transparente Infrarotdioden (IREDs) und Leuchtdioden (LEDs). Die Schichten des Schichtenstapels solcher Lichtquellen sind auf einem Wachstumssubstrat in Form eines Kristalls epitaktisch aufeinander gewachsen. Ein Teil der im Schichtenstapel erzeugten Photonen wird aus dem Stapel in Richtung zum Wachstumssubstrat emittiert und dort absorbiert.

Für derartige Halbleiterlichtquellen möglichst hoher optischer Leistung wird versucht, die Absorption im Wachstumssubstrat weitgehend zu vermeiden. Mittel hierzu sind - außer der in wenigen Fällen möglichen Verwendung von für die Photonen transparenten Wachstumssubstraten - eingefügte Bragg-Reflektoren aus Halbleitermaterial zwischen dem Wachstumssubstrat und dem gewachsenen Schichtenstapel oder das.nachträgliche Anbringen eines für die Photonen transparenten Stützkörpers an den Schichtenstapel, beispielsweise durch Waferbonden.

Beim nachträglichen Anbringen des transparenten Stützkörpers an den Schichtenstapel wird der Stützkörper flächig und derart innig mit der vom Wachstumssubstrat abgekehrten Oberfläche des Schichtenstapels verbunden, daß der Stützkörper ähnlich unmittelbar fest mit dem Schichtenstapel verbunden ist, wie das Wachstumssubstrat selbst. Dieses unmittelbare Anbringen wird beispiesweise durch Anschmelzen oder Anwachsen des transparenten Stützkörpers an den Schichtenstapel vorgenommen. Nach dem Anbringen wird das Wachstumssubstrat vom Schichtenstapel entfernt, wonach Schichtenstapel und transparenter Stützkörper gemeinsam als ähnlich einheitlicher Verbundkörper wie vorher Schichtenstapel und Wachstumssubstrat vorliegen und der transparente Stützkörper den Schichtenstapel jetzt wie ursprünglich das Wachstumssubstrats stützt. In diesem Zustand wird der Schichtenstapel elektrisch kontaktiert.

Die Druckschrift US 5,557,115 A betrifft ein lichtemittierendes Halbleiterbauteil mit einem Träger.

In der Druckschrift JP S64-084759 A ist eine Leuchtdiode mit einer Ausnehmung in einer Halbleiterschichtenfolge beschrieben.

Aus der Druckschrift GB 2 019 643 A ist eine Leuchtdiode mit Durchkontaktierungen, die über Dotierung erzeugt sind, bekannt.

Eine Leuchtdiodenstruktur mit einer Ausnehmung findet sich in der Druckschrift EP 0720 241 A2.

Ferner sind eine Leuchtdiode und ein Herstellungsverfahren hierfür in der Druckschrift US 5,578,162 A offenbart.

Lichtemittierende Halbleiterbauteile aus einer III-Nitrid-Zusammensetzung sind der Druckschrift US 5,652,438 A zu entnehmen.

Der im Anspruch 1 angegebenen Erfindung liegt die Aufgabe zugrunde, eine Halbleiterlichtquelle mit geringer Photonenabsorption bereitzustellen, die sowohl baulich einfacher als auch einfacher herzustellen ist.

Bei der erfindungsgemäßen Halbleiterlichtquelle ist weder ein Photonen absorbierendes Wachstumssubstrat noch ein Stützkörper zum Stützen des Schichtenstapels vorhanden, der innig mit dem Schichtenstapel zu einem einheitlichen Verbundkörper verbunden und für im Schichtenstapel erzeugte Photonen transparent ist und der den Aufbau und die Herstellung der Lichtquelle verkompliziert.

Die erfindungsgemäße Lichtquelle besteht im wesentlichen nur noch aus dem Schichtenstapel einer geringen Gesamtdicke von höchstens 50 µm allein, der zur elektrischen Kontaktierung und mechanischen Stabilität an einem gesonderten Trägerkörper angeordnet und durch ein wenig Aufwand erforderndes gesondertes Verbindungsmittel mit diesem Körper verbunden ist. Eine die Herstellung verkomplizierende innige flächige Verbindung zwischen der Oberfläche dieses dünnen Schichtenstapels und einem transparenten Stützkörper ist vorteilhafterweise nicht mehr erforderlich.

Aufgrund der Bauweise der erfindungsgemäßen Lichtquelle kann eine dem Trägerkörper zugekehrte Oberfläche des Schichtenstapels eine brechende Fläche sein, die an ein optisches Medium mit einer relativ zu einer Brechzahl des Schichtenstapels deutlich kleineren Brechzahl, beispielsweise Luft, grenzt und aufgrund des relativ großen Brechzahlsprungs im Schichtenstapel erzeugte Photonen teilweise reflektiert, die dann nicht aus dem Schichtenstapel in den Trägerkörper gelangen, sondern zur optischen Leistung der Lichtquelle beitragen.

Besonders vorteilhaft ist es, wenn an der dem Trägerkörper zugekehrten Oberfläche des Schichtenstapels eine Reflektoreinrichtung zum Reflektieren der im Schichtenstapel erzeugten und auf diese Fläche treffenden Photonen zurück in den Schichtenstapel ausgebildet ist.

Dies hat den Vorteil zum einen, daß alle im Schichtenstapel erzeugten Photonen, die auf die Reflektoreinrichtung treffen, nicht in den gesonderten Trägerkörper gelangen, sondern in Richtung vom Trägerkörper fort reflektiert werden und zur optischen Leistung der erfindungsgemäßen Lichtquelle beitragen können, zum andern, daß der gesonderte Trägerkörper auch bei Lichtquellen hoher optischer Leistung aus einem beliebigen Material bestehen kann, insbesondere aus einem die im Schichtenstapel erzeugten Photonen absorbierenden Material.

Als Reflektoreinrichtung sind alle reflektierend wirkenden Mittel geeignet, die an der dem Trägerkörper zugekehrten Oberfläche des Schichtenstapels ausgebildet werden können wie beispielsweise eine auf dieser Oberfläche aufgebrachte reflektierende Schicht oder ein in dieser Oberfläche ausgebildetes reflektierendes optisches Gitter, beispielsweise ein Braggspiegel.

Bei einer bevorzugten und vorteilhaften Ausgestaltung der erfindungsgemäßen Lichtquelle weist die Reflektoreinrichtung einen auf der dem Trägerkörper zugekehrten Oberfläche des Schichtenstapels angeordneten reflektierenden Kontakt auf. Dieser Kontakt kann zum elektrischen Anschließen des Schichtenstapels an den Trägerkörper verwendet werden, und da er reflektierend wirkt, sind keine zusätzlichen reflektierend wirkenden Mittel notwendig. Dies vereinfacht die Herstellung der erfindungsgemäßen Lichtquelle.

Der Schichtenstapel der erfindungsgemäßen Lichtquelle kann vorteilhafterweise nur aus den für die Funktion der Halbleiterlichtquelle allein notwendigen epitaktisch gewachsenen Schichten bestehen.

Eine typische Gesamtdicke von auf Wachstumssubstraten gewachsenen und nur aus den für die Funktion der Lichtquelle notwendigen epitaktisch gewachsenen Schichten allein bestehenden Schichtenstapeln bekannter Diodenlichtquellen wie LEDs und IREDS insbesonderer hoher optischer Leistung liegt im Bereich zwischen 3 µm und 15 µm. Mit der Erfindung können vorteilhafterweise solche Diodenlichtquellen mit derart dünnen Schichtenstapeln realisiert werden und entsprechend kann bei der erfindungsgemäßen Lichtquelle vorteilhafterweise der alleinige Schichtenstapel eine solche geringe Gesamtdicke im Bereich von nur 3 µm bis 15 µm aufweisen.

Insbesondere ist die Erfindung vorteilhafterweise zur Realisierung von IREDs und LEDs hoher optischer Leistung geeignet und entsprechend ist in diesem Fall der Schichtenstapel der erfindungsgemäßen Lichtquelle der Schichtenstapel einer IRED oder einer LED, wobei es in diesem Fall überdies vorteilhaft ist, eine Reflektoreinrichtung zu verwenden.

Die Erfindung ist aber nicht auf solche Diodenlichtquellen beschränkt, sondern auch auf andere Halbleiterlichtquellen, beispielsweise Halbleiterlaser anwendbar, wobei unter Umständen das Problem eines Austritts von im Schichtenstapel erzeugten Photonen durch die dem Trägerkörper zugekehrte Oberfläche unbedeutend sein kann, so daß auf Maßnahmen zur Verhinderung eines solchen Austritts von vorneherein verzichtet werden kann.

Das gesonderte Verbindungsmittel zum aneinander befestigen von Schichtenstapel und gesondertem Trägerkörper besteht vorzugsweise aus einem eine feste Verbindung zwischen dem Schichtenstapel und diesem Trägerkörper herstellenden Haftmittel, vorzugsweise ein Klebstoff und/oder ein Lot.

Lot und/oder elektrisch leitender Klebstoff werden vorzugsweise dort verwendet, wo eine elektrisch leitende Verbindung nicht stört oder gar notwendig ist, elektrisch isolierender Klebstoff dort, wo eine elektrisch leitende Verbindung zu vermeiden ist.

Auch andere Verbindungsmittel, beispielsweise eine Klemmverbindung, können verwendet werden.

Eine erfindungsgemäße Diodenlichtquelle, insbesondere eine Quelle hoher optischer Leistung, ist derart baulich einfach ausgebildet, daß der Schichtenstapel
- Schichten aus Halbleitermaterial voneinander verschiedenen Leitfähigkeitstyps aufweist, zwischen denen ein optisch aktiver Übergang von einem zu einem anderen Leitfähigkeitstyp zur Erzeugung der Photonen ausgebildet ist, und
- Halbleitermaterial eines Leitfähigkeitstyps des Schichtenstapels und Halbleitermaterial des anderen Leitfähigkeitstyps elektrisch voneinander getrennt am Trägerkörper kontaktiert sind.

In diesem Fall umfasst der Trägerkörper
- einen elektrischen Kontakt, an den Halbleitermaterial eines Leitfähigkeitstyps des Schichtenstapels angeschlossen ist, und
- einen von dem einen Kontakt getrennten anderen elektrischen Kontakt, an den Halbleitermaterial des anderen Leitfähigkeitstyps des Schichtenstapels angeschlossen ist.

Ein elektrischer Anschluß von Halbleitermaterial des Schichtenstapels der erfindungsgemäßen Lichtquelle an einen Kontakt des Trägerkörpers ist durch einen dieses Halbleitermaterial unmittelbar kontaktierenden Halbleiterkontakt an diesen Kontakt des Trägerkörpers angeschlossen.

Der Halbleiterkontakt ist vorzugsweise ein ohmscher Kontakt, kann unter Umständen aber auch ein Schottky-Kontakt sein.

Zum Verbinden eines Kontaktes des Trägerkörpers mit einem Halbleiterkontakt wird vorzugsweise Lot und/oder leitender Klebstoff verwendet.

Bei Diodenlichtquellen sind die Schichten aus Halbleitermaterial voneinander verschiedenen Leitfähigkeitstyps, zwischen denen der optisch aktive Übergang vom einen zum davon verschiedenen anderen Leitfähigkeitstyp ausgebildet ist, üblicherweise parallel zu einer Ebene der Schichten übereinander angeordnet, so daß sie sich senkrecht zu dieser Ebene auf verschiedenen Seiten des Übergangs befinden. Entsprechend muß bei einer solchen Diodenlichtquelle Halbleitermaterial eines Leitfähigkeitstyps auf einer Seite und Halbleitermaterial des von diesem einen Leitfähigkeitstyp verschiedenen anderen Leitfähigkeitstyps auf der anderen Seite des Übergangs kontaktiert und an die elektrisch voneinander getrennten Kontakte des Trägerkörpers angeschlossen werden.

Halbleitermaterial eines Leitfähigkeitstyps und Halbleitermaterial des davon verschiedenen anderen Leitfähigkeitstyps des Schichtenstapels der erfindungsgemäßen Lichtquelle sind in einem solchen Fall jedoch auf der gleichen Seite des Übergangs, aber elektrisch voneinander getrennt an die elektrisch voneinander getrennten Kontakte des Trägerkörpers angeschlossen sein, wenn
- der Schichtenstapel in einer zu einer Ebene der Schichten im wesentlichen parallelen Oberfläche eine Vertiefung aufweist, die sich von dieser Oberfläche aus in Richtung senkrecht zur Ebene der Schichten durch einen Übergang von Halbleitermaterial eines Leitfähigkeitstyps zu Halbleitermaterial eines vom einen Leitfähigkeitstyp verschiedenen anderen Leitfähigkeitstyps des Schichtenstapels hindurch erstreckt, und wenn
- das Halbleitermaterial des einen Leitfähigkeitstyps an einen Kontakt des Trägerkörpers und das Halbleitermaterial des anderen Leitfähigkeitstyps in der Vertiefung an einen elektrisch von diesem einen Kontakt des Trägerkörpers getrennten anderen Kontakt des Trägerkörpers angeschlossen ist.

Der Schichtenstapel ist dabei derart flach auf dem Trägerkörper angeordnet, daß die Oberfläche des Schichtenstapels, in der die Vertiefung ausgebildet ist, dem Trägerkörper zugekehrt ist.

Der Anschluß der Halbleitermaterialien voneinander verschiedenen Leitfähigkeitstyps des Schichtenstapels an die voneinander getrennten Kontakte des Trägerkörpers kann in diesem Fall vorteilhafterweise auf besonders kurzem Weg hergestellt werden, wenn die elektrisch voneinander getrennten Kontakte des Trägerkörpers auf einer dem Schichtenstapel zugekehrten Oberfläche des Trägerkörpers angeordnet sind, vorzugsweise wie folgt:
Auf der dem Trägerkörper zugekehrten Oberfläche des Schichtenstapels sind ein Halbleiterkontakt, der zwischen dieser Oberfläche und dem optisch aktiven Übergang befindliches Halbleitermaterial des Stapels unmittelbar kontaktiert, und ein anderer Kontakt angeordnet, der elektrisch von diesem Halbleiterkontakt und dem Halbleitermaterial zwischen der Oberfläche und dem optisch aktiven Übergang des Stapels getrennt ist.

Der Halbleiterkontakt ist an einen Kontakt des Trägerkörpers und der andere Kontakt des Schichtenstapels an einen elektrisch von diesem einen Kontakt des Trägerkörpers getrennten anderen Kontakt des Trägerkörpers angeschlossen, beispielsweise durch unmittelbares Berühren.

In der Vertiefung ist ein Halbleiterkontakt angeordnet, der Halbleitermaterial des Schichtenstapels, das sich auf der vom Trägerkörper abgekehrten Seite des optisch aktiven Übergangs des Stapels befindet, unmittelbar kontaktiert. Dieser Halbleiterkontakt in der Vertiefung ist elektrisch vom Halbleitermaterial des einen Leitfähigkeitstyps auf der dem Trägerkörper zugekehrten Seite des optisch aktiven Übergangs, von dem dieses Material kontaktierenden Halbleiterkontakt und von dem mit diesem Anschlußkontakt verbundenen Kontakt des Trägerkörpers getrennt, dagegen elektrisch mit dem anderen Kontakt des Schichtenstapels verbunden.

Der mit dem Halbleiterkontakt in der Vertiefung verbundene andere Kontakt des Schichtenstapels und eine elektrische Verbindung dieser beiden Kontakte können vorteilhafterweise aus dem gleichen Material wie dieser Halbleiterkontakt bestehen, wobei die Verbindung auf einer Seitenwand der Vertiefung aufgebracht sein kann. Die Halbleiterlichtquelle ist so eingerichtet, daß der Schichtenstapel zwei voneinander abgekehrte und in einem Winkel zur Ebene der Schichten stehende Endflächen aufweist, welche die Oberfläche des Schichtenstapels, in der die Vertiefung ausgebildet ist, auf zueinander entgegengesetzten Seiten begrenzen, und daß sich die Vertiefung in dieser Oberfläche von einer Endfläche bis zur anderen erstreckt.

Auf der vom Trägerkörper abgekehrten Seite des optisch aktiven Übergangs befindliches Halbleitermaterial des Schichtenstapels weist vorzugsweise eine hohe elektrische Leitfähigkeit senkrecht zur Ebene der Schichten des Schichtenstapels auf.

Die von der erfindungsgemäßen Lichtquelle abgegebene optische Leistung wird im Schichtenstapel erzeugt und tritt durch die Oberfläche des Schichtenstapels aus. Zu dieser optischen Leistung sollten möglichst alle im Schichtenstapel erzeugten Photonen beitragen. Dazu ist zum einen notwendig, daß möglichtst wenig dieser Photonen im Stapel absorbiert werden, d.h. der Stapel sollte für diese Photonen möglichst transparent sein, zum anderen sollten möglichst viele dieser Photonen, am besten alle, durch die Oberfläche des Schichtenstapels austreten.

Größtmögliche Transparenz des Schichtenstapels wird erreicht, wenn die Schichten des Schichtenstapels, allenfalls ausgenommen in einem Bereich eines optisch aktiven Übergangs, für im Schichtenstapel erzeugte Photonen transparent sind.

Zur Begünstigung des Austritts der im Schichtenstapel erzeugten Photonen aus dem Schichtenstapel ist zweckmäßigerweise eine Einrichtung zur Erleichterung eines Austritts von im Schichtenstapel erzeugten Photonen aus dem Schichtenstapel vorgesehen.

Als Einrichtung zur Erleichterung des Austritts von Photonen ist jedes Mittel geeignet, das den Austritt der Photonen durch die Oberfläche des Schichtenstapels fördert. Beispielsweise kann ein solches Mittel eine auf die Oberfläche aufgebrachte Antireflexschicht sein, die den Brechzahlsprung an der optisch brechenden Oberfläche von höherer Brechzahl im Inneren des Stapels zu niedrigerer Brechzahl außerhalb des Stapels herabsetzt und so den Austritt der Photonen erleichtert.

Allerdings ist das Aufbringen einer zusätzlichen Reflexschicht oft unerwünscht, beispielsweise weil die Herstellung der Lichtquelle nicht unerheblich aufwendig und verteuert wird.

Ein Weg zu einer einfachen Realisierung einer Einrichtung zur Erleichterung des Austritts von Photonen besteht in der Vermeidung von planparallelen reflektierenden Oberflächenabschnitten des Schichtenstapels, d.h. voneinander abgekehrte Oberflächenabschnitte sollen nicht eben und/oder parallel zueinander sein. Derartige Oberflächenabschnitte können allein durch geometrische Gestaltgebung des Schichtenstapels und damit ohne großen Aufwand realisiert werden.

Planparallele reflektierenden Oberflächenabschnitten sind vermieden, indem die Einrichtung zur Erleichterung des Austritts von Photonen so ausgebildet ist, daß sie
- schräg in einem Winkel zueinander angeordnete Oberflächenabschnitte aufweist oder zusätzlich noch
- ein auf der Oberfläche des Schichtenstapels ausgebildetes Relief aufweist, das vorzugsweise fein strukturiert ist.

Schräg in einem Winkel zueinander angeordnete Oberflächenabschnitte sind zwei voneinander abgekehrte und in einem Winkel zur Ebene der Schichten stehende Endflächen, die in dieser Ebene schräg in einem Winkel zueinander verlaufen und von denen zumindest eine Endfläche schräg in einem Winkel zur Ebene angeordnet ist.

Ein auf der Oberfläche des Schichtenstapels ausgebildetes fein strukturiertes Relief kann durch Aufrauhen der Oberfläche oder durch eine unebene Mikrostrukturierung der Oberfläche erzeugt werden. Ein derartiges Relief ist vorzugsweise auf der vom Trägerkörper abgekehrten Oberfläche des Schichtenstapels ausgebildet, kann aber auch auf dessen dem Trägerkörper zugekehrten Oberfläche und auf allen anderen Oberflächenabschhnitten vorgesehen sein.

Schräg in einem Winkel zur Ebene der Schichten angeordnete Oberflächenabschnitte des Schichtenstapels, darunter eine, mehrere oder alle Endflächen des Stapels und/oder zumindest eine Wandfläche einer Vertiefung sind vorzugsweise in Winkeln kleiner als 30° bei unvergossenen und kleiner als 40° bei vergossenen erfindungsgemäßen Lichtquellen zur Ebene geneigt, wobei die Richtung der Neigung beliebig ist.

Generell können in einem Winkel zur Ebene der Schichten angeordnete Oberflächenbereiche des Schichtenstapels beliebig geformt sein. Auch die Form der Grundfläche oder des Umrisses des Schichtenstapels in senkrechter Projektion auf eine zur Ebene der Schichten parallele Ebene ist generell beliebig wählbar.

Vorteilhafterweise kann der erfindungsgemäße Schichtenstapel in herkömmlicher Weise III-V-Halbleitermaterial aufweisen, darunter alle gebräuchlichen III-V-Verbindungen von In, GA, Al, As, P, N auf GaAs-, InP-, GaP- oder GaN-Basis.

Ein optisch aktiver Übergang kann ein pn- oder pin-Übergang sein. Vorteilhafterweise kann der erfindungsgemäße Schichtenstapel in herkömmlicher Weise so ausgebildet sein, daß der optisch aktive Übergang eine zwischen zwei Schichten aus Halbleitermaterial zueinander verschiedenen Leitfähigkeitstyps des Schichtenstapels angeordnete aktive Schicht aufweist, in der Photonen erzeugbar sind. Bis auf die aktive Schicht sind alle anderen Schichten aus Halbleitermaterial des Schichtenstapels möglichst transparent.

Der Trägerkörper besteht vorteilhafterweise aus einem Material, das einen ähnlichen thermischen Ausdehnungskoeffizienten wie derSchichtenstapel aufweist, d.h. die thermischen Ausdehnungskoeffizienten der Materialien des Trägerkörpers und des Schichtenstapels weichen bei den Temperaturen, die beim Betrieb der erfindungsgemäßen Halbleiterlichtquelle auftreten oder denen die Quelle ausgesetzt wird, allenfalls so gering voneinander ab, daß keine schädlichen temperaturbedingten Verformungen des Schichtenstapels auftreten, welche dessen optische Qualität beeinträchtigen und eine optische und/oder mechanische Langzeitstabilität der erfindungsgemäßen Lichtquelle beeinträchtigen können.

Der Trägerkörper besteht vorzugsweise aus einem gut wärmeleitenden Material, das eine gute Wärmeableitung vom Schichtenstapel fort gewährleistet.

Ein für den Trägerkörper gut geeignetes Material, dessen thermischer Ausdehnungskoeffizient gut an den des Schichtenstapels angepaßt ist und das eine gute Wärmeleitfähigkeit aufweist, ist Silizium.

Der elektrische Anschluß der erfindungsgemäßen Lichtquelle von außen erfolgt über die elektrisch voneinander getrennten Kontakte des Trägerkörpers, beispielsweise durch Bonddrähte und/oder Lot. Besteht der Trägerkörper aus elektrisch leitendem Material, können zwei vorteilhafte Varianten unterschieden werden:
a1) Elektrisch voneinander getrennte Kontakte des Trägerkörpers bestehen aus von der elektrisch leitenden Oberfläche des Trägerkörpers isolierten Kontakten, oder
a2) ein Kontakt ist zweckmäßigerweise ein von der elektrisch leitenden Oberfläche des Trägerkörpers isolierter Kontakt und ein elektrisch von diesem Kontakt getrennter anderer Kontakt ist von der Oberfläche des Trägerkörpers selbst gebildet.

In jedem dieser Fälle sind die Kontakte vorteilhafterweise auf einer dem Schichtenstapel zugekehrten Oberfläche des Trägerkörpers angeordnet, wobei sich ein besonders kurzer und einfacher Anschluß der Halbleitermaterialien verschiedenen Leitfähigkeitstyps des Schichtenstapels auf beiden Seiten dessen optisch aktiven Übergangs an diese Kontakte dann ergibt, wenn diese Materialien auf der dem Trägerkörper zugekehrten Oberfläche des Stapels kontaktiert sind, weil sich dann die Kontakte auf der Oberfläche des Trägerkörpers und diese Halbleitermaterialien kontaktierende Halbleiterkontakte auf der dieser Oberfläche zugekehrten Oberfläche des Schichtenstapels unmittelbar gegenüberliegen und berühren können.

Im Fall a2 kann es vorteilhaft sein, wenn der elektrische Anschluß der erfindungsgemäßen Lichtquelle von außen über die elektrisch voneinander getrennten Kontakte auf dem Trägerkörper so ausgeführt ist, daß zum einen der elektrisch isolierte Kontakt des Trägerkörpers und zum anderen sein von der Oberfläche des Trägerkörpers selbst gebildete Kontakt indirekt durch den elektrisch leitenden Trägerkörper hindurch von außen kontaktiert ist, vorzugsweise so, daß eine vom Schichtenstapel abgekehrte Oberfläche des Trägerkörpers kontaktiert ist.

Die erfindungsgemäße Lichtquelle wird so hergestellt, daß auf einem Wachstumssubstrat epitaktisch der für die Lichtquelle bestimmte Schichtenstapel gewachsen, der mit dem Wachstumssubstrat verbundene Schichtenstapel auf dem Trägerkörper, der die elektrisch voneinander getrennten Kontakte aufweist, angeordnet und mit dem Verbindungsmittel befestigt und elektrisch kontaktiert wird, und danach die derart auf dem Trägerkörper befestigte Schichtenfolge vom Wachstumssubstrat getrennt wird.

Dieses Verfahren wird in bezug auf das Trennen des Schichtenstapels vom Wachstumssubstrat bevorzugterweise so ausgeführt, daß auf dem Wachstumssubstrat epitaktisch eine Zwischenschicht aus einem Material gewachsen wird, das mit einem selektiv wirkenden Ätzmittel ätzbar ist, welches die Materialien der Schichten des Schichtenstapels nicht oder weniger stark angreift, als das Material der Zwischenschicht, daß auf der Zwischenschicht epitaktisch die Schichten des Schichtenstapels gewachsen werden, und daß zum Trennen des Schichtenstapels vom Wachstumssubstrat die Zwischenschicht mit dem selektiv wirkenden Ätzmittel geätzt wird. Dieses Verfahren kann beispielsweise mit einem Wachstumssubstrat aus GaAs, einem Schichtenstapel auf der Basis von InGaAlAs, einer Zwischenschicht aus AlAs und einem flußsäurehaltigen Ätzmittel aus durchgeführt werden.

Bei der Herstellung der erfindungsgemäßen Halbleiterlichtquellen wird vorteilhafterweise so vorgegangen, daß mehrere Schichtenstapel im Waferverbund als Inseln oder Meseten im Raster mehrerer Trägerkörper präpariert werden, wobei die Form der Grundfläche jedes Schichtenstapels beliebig wählbar ist, vorzugsweise mit spitzwinklig zueinander geordneten Seiten.

Die Erfindung wird in der nachfolgenden Beschreibung an Hand der Figuren beispielhaft näher erläutert. Es zeigen:
- Figur 1: eine Seitenansicht eines Ausführungsbeispiels einer erfindungsgemäßen Halbleiterlichtquelle,
- Figur 2: eine Draufsicht auf das Ausführungsbeispiel nach Figur 1,
- Figur 3: eine Modifikation des Ausführungsbeispiels nach den Figuren 1 und 2 in der Seitenansicht nach Figur 1 und
- Figur 4: den Schichtenstapel und Trägerkörper des Ausführungsbeispiel nach den Figuren 1 und 2 in der Seitenansicht nach Figur 1, wobei der Schichtenstapel noch innig mit dem Wachstumssubstrat verbunden und noch nicht auf dem Trägerkörper befestigt ist.

Die Figuren sind schematisch und nicht maßstäblich.

In den Figuren ist der Schichtenstapel mit 1 und der Trägerkörper mit 2 bezeichnet. Die Schichten des Schichtenstapels 1 sind parallel zu einer definierten Ebene 100 der Schichten angeordnet. Der Schichtenstapel 1 weist zwei voneinander abgekehrte Oberflächen 14 und 14' auf, zwischen denen die Gesamtdicke d des Stapels 1 gemessen ist.

Erfindungswesentlich ist, daß der Schichtenstapel 1 in der Gesamtdicke d von höchstens 50 µm allein, d.h. ohne ein Wachstumssubstrat und/oder einen sonstigen innig mit dem Stapel 1 verbundenen Stützkörper an dem gesonderten, elektrisch voneinander getrennte Kontakte 21 und 22 aufweisenden Trägerkörper 2 angeordnet ist, und daß Schichtenstapel 1 und Trägerkörper 2 durch ein gesondertes Verbindungsmittel 3 aneinander befestigt sind.

Der Schichtenstapel 1 kann jeden Aufbau aus epitaktisch aufeinander gewachsenen Schichten aufweisen, den eine Halbleiterlichtquelle haben kann.

Bei den dargestellten Ausführungsbeispielen ist die Halbleiterlichtquelle eine Diodenlichtquelle, bei welcher der Schichtenstapel 1 aus epitaktisch aufeinander gewachsenen Schichten aus Halbleitermaterial voneinander verschiedenen Leitfähigkeitstyps besteht, zwischen denen zumindest ein Photonen erzeugender optisch aktiver Übergang von einem zum anderen Leitfähigkeitstyp ausgebildet ist, wobei Halbleitermaterial eines Leitfähigkeitstyps und Halbleitermaterial des anderen Leitfähigkeitstyps des Schichtenstapels 1 voneinander getrennt elektrisch kontaktiert sind.

Eine typische Gesamtdicke d eines Schichtenstapels 1 herkömmlicher Diodenlichtquellen liegt im Bereich zwischen 3 µm und 15 µm. Auch bei einer erfindungsgemäßen Diodenlichquelle weist der allein am gesonderten Trägerkörper 2 angeordnet1 Schichtenstapel 1 vorteilhafterweise eine Gesamtdicke d im Bereich von 3 µm bis 15 µm auf.

Wie bei herkömmlichen Diodenlichtquellen ist auch bei einer erfindungsgemäßen Diodenlichtquelle dem optisch aktiven Übergang üblicherweise wenigstens eine aktive Schicht des Schichtenstapels 1 zugeordnet, in der Photonen dieses Übergangs erzeugt werden.

Bei den in den Figuren dargestellten Diodenlichtquellen ist eine einfachste Form eines Schichtenstapels 1 angenommen. Dieser besteht aus einer Schicht 11 aus Halbleitermaterial eines Leitfähigkeitstyps, einer Schicht 13 aus Halbleitermaterial des anderen Leitfähigkeitstyps und einer aktiven Schicht 12 zur Erzeugung von Photonen, die zwischen der Schicht 11 und Schicht 13 angeordnet ist.

Als Ebene 100 der parallel zueinander angeordneten Schichten 11, 12 und 13 ist eine zentrale Schichtebene der aktiven Schicht 12 genommen.

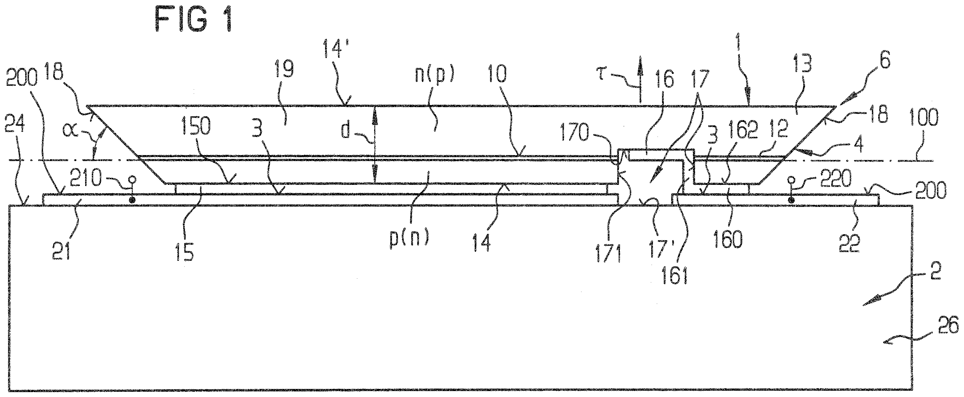

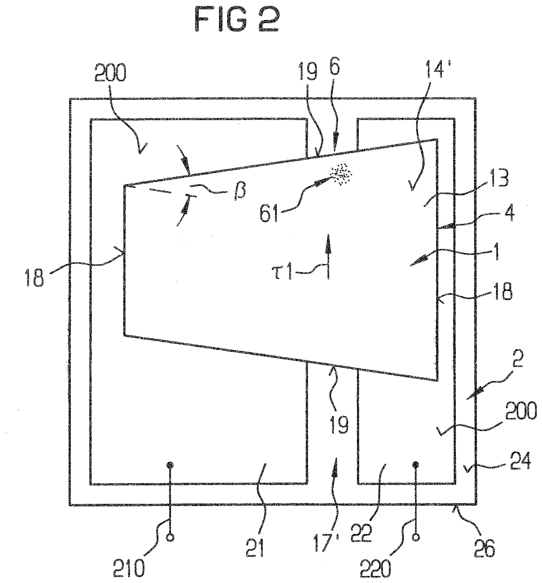

Der Schichtenstapel 1 ist in den Figuren 1, 3 und 4 so dargestellt, daß die Ebene 100 der Schichten horizontal und senkrecht zur Zeichenebene und in der Figur 2 parallel zur Zeichenebene angeordnet ist.

Der Photonen erzeugende optisch aktive Übergang ist mit 10 bezeichnet, befindet sich zwischen der Schicht 11 und der Schicht 13 und erstreckt sich parallel zur Ebene 100 der Schichten. Zum Übergang 10 ist die aktive Schicht 12 zu zählen.

Die Zahl der epitaktisch gewachsenen Schichten des Schichtenstapels 1 ist nicht auf drei beschränkt und kann größer sein. Beispielsweise können die Schichten 11, 12 und 13 jeweils laminiert sein.

Das Halbleitermaterial der Schichten 11 und 13 des Schichtenstapels 1 so gewählt, daß es für in der zwischen diesen Schichten 11 und 12 angeordneten aktiven Schicht 12 erzeugte Photonen transparent ist.

Bei den dargestellten Beispielen sind Trägerkörper 2 und Schichtenstapel 1 relativ zueinander so angeordnet, daß eine dem Stapel 1 zugekehrte Oberfläche 24 des Trägerkörpers 2 und die Ebene 100 der Schichten des Stapels 1 im wesentlichen parallel zueinander sind. Von den beiden voneinander abgekehrten Oberflächen 14 und 14' des Trägerkörpers 2 liegt die Oberfläche 14 der Oberfläche 24 des Trägerkörpers 2 gegenüber.

Die elektrisch voneinander getrennten Kontakte 21 und 22 des Trägerkörpers 2 sind beim Beispiel nach den Figuren 1, 2 und 4 Metallschichten, die zwischen den einander gegenüberliegenden und im wesentlichen zueinander parallelen Oberflächen 14 und 24 des Schichtenstapels 1 und Trägerkörpers 2 angeordnet und auf der Oberfläche 24 des Trägerkörpers 2 befestigt sind.

Besteht der Trägerkörper 2 aus elektrisch leitendem Material, beispielsweise Metall, müssen die Kontakte 21 und 22 von der Oberfläche 24 isoliert sein. In jedem Fall müssen sie fest mit der Oberfläche 24 verbunden sein, beispielsweise mittels Klebstoffs oder durch Aufdampfen.

Der Schichtenstapel 1 ist beispielsweise so angeordnet, daß sich die Schicht 11 zwischen dem Trägerkörper 2 und dem optisch aktiven Übergang 10 befindet, wobei die der Oberfläche 24 des Trägerkörpers 2 gegenüberliegende Oberfläche 14 des Schichtenstapels 1 aus dem Halbleitermaterial dieser Schicht 11 besteht.

Auf dieser Oberfläche 14 des Schichtenstapels 1 sind ein Halbleiterkontakt 15, der das Halbleitermaterial der Schicht 11 des Stapels 1 unmittelbar kontaktiert, und ein anderer Kontakt 160, der elektrisch vom Halbleiterkontakt 15 und dem Halbleitermaterial der Schicht 11 getrennt ist, angeordnet. Der Halbleiterkontakt 15 ist vorzugsweise ein ohmscher Kontakt, könnte aber je nach Aufbau des Schichtenstapels 1 auch beispielsweise ein Schottky-Kontakt sein.

Der Halbleiterkontakt 15 liegt unmittelbar auf dem Kontakt 21 und der andere Kontakt 160 unmittelbar auf dem Kontakt 22 des Trägerkörpers 2 auf. Es könnte auch umgekehrt sein.

In der Oberfläche 14 des Stapels 1 ist eine Vertiefung 17 ausgebildet, die sich von dieser Oberfläche 14 in Richtung r senkrecht zur Ebene 100 der Schichten in die Tiefe des Schichtenstapels 1 bis in die Schicht 13 erstreckt, d.h. in das Halbleitermaterial des vom einen Leitfähigkeitstyp des Halbleitermaterials der Schicht 11 verschiedenen anderen Leitfähigkeitstyps, das sich im Unterschiched zu dem sich zwischen der Oberfläche 14 und dem Übergang 10 des Stapels 1 befindenden Halbleitermaterial der Schicht 11 auf der von dieser Oberfläche 14 abgekehrten Seite des optisch aktiven Übergangs 10 befindet.

In der Vertiefung 17 ist ein Halbleiterkontakt 16 angeordnet, der das Halbleitermaterial des anderen Leitfähigkeitstyps der Schicht 13 unmittelbar kontaktiert, beispielsweise auf einer Bodenfläche 170 der Vertiefung 17, und der vorzugsweise ein ohmscher Kontakt ist. Dieser Halbleiterkontakt 16 ist elektrisch mit dem anderen Kontakt 160 verbunden, beispielsweise durch eine elektrische Verbindungsleitung 161.

Der Halbleiterkontakt 16, die elektrische Verbindungsleitung 161 und der andere Kontakt 160 müssen elektrisch vom Halbleitermaterial der Schicht 11, dem dieses Material kontaktierenden Halbleiter-Anschluß-kontakt 15 und dem Kontakt 21 des Trägerkörpers 2 getrennt sein.

Der andere Kontakt 160 und die elektrische Verbindungsleitung 161 können vorteilhafterweise aus dem gleichen Material wie der Halbleiterkontakt 16 bestehen. Die elektrische Verbindungsleitung 161 kann auf einer der seitlichen Wandflächen 171 der Vertiefung 17 aufgebracht sein.

Die elektrische Trennung des anderen Kontakts 160 und der Verbindungsleitung 161 vom Halbleitermaterial der Schicht 11 des Stapels 1 kann durch eine elektrisch isolierende Klebstoffschicht 162 zwischen der Schicht 11 und dem anderen Kontakts 160 sowie der Verbindungsleitung 161 realisiert sein, die auch die feste Verbindung des anderen Kontakts 160 mit dem Schichtenstapel herstellt.

Bei den dargestellten Beispielen besteht die Schicht 11 aus p-dotiertem Halbleitermaterial, d.h. Material vom Leitfähigkeitstyp p, und die Schicht 13 aus n-dotiertem Halbleitermaterial, d.h Material vom Leitfähigkeitstyp n. Es könnte auch umgekehrt sein, d.h. die Schicht 11 aus n-dotiertem und die Schicht 13 aus p-dotiertem Halbleitermaterial bestehen.

In jedem Fall sollte das Halbleitermaterial der Schicht 13 auf der vom Trägerkörper 2 abgekehrten Seite des Übergangs 10 des Schichtenstapels 1 eine höhere elektrische Leitfähigkeit senkrecht zur Ebene 100 der Schichten aufweist als das Halbleitermaterial der Schicht 11 zwischen dem Übergang 10 und dem Trägerkörper 2.

Das gesonderte Verbindungsmittel 3 zur Befestigung des dünnen Schichtenstapels 1 an dem Trägerkörper 2 besteht beispielsweise im wesentlichen aus einem elektrisch leitenden Klebstoff und/oder einem Lot, das den mit der Schicht 11 verbundenen Halbleiterkontakt 15 des Schichtenstapels 1 fest mit dem zugeordneten Kontakt 21 des Trägerkörpers 2 und den ebenfalls fest mit der Schicht 11 verbundenen anderen Kontakt 160 des Stapels 1 fest mit dem zugeordneten Kontakt 22 des Trägerkörpers 2 verbindet. Vorraussetzung bei dieser bevorzugten Art der Herstellung einer festen Verbindung zwischen Schichtenstapel 1 und Trägerkörper 2 über Kontakte ist die gegebene feste Verbindung des Halbleiterkontakts 15 und anderen Kontakt 160 mit dem Schichtenstapel 1 und der Kontakte 21 und 22 mit dem Trägerkörper 2.

Die Befestigung des Schichtenstapels 1 mit dem Trägerkörper 2 muß nicht über Kontakte hergestellt werden. Beispielsweise könnten die einander gegenüberliegenden Oberflächen 14 und 24 des Stapels 1 und Trägerkörpers 2 an kontaktfreien Stellen direkt durch ein Verbindungsmittel 3, beispielsweise einen geeigneten Klebstoff fest miteinander verbunden sein.

Der Schichtenstapel 1 weist zwei voneinander abgekehrte und schräg in einem Winkel zur Ebene 100 der Schichten stehende Endflächen 19 auf, welche die Oberfläche 14 des Schichtenstapels 1, in der die Vertiefung 17 ausgebildet ist, auf zueinander entgegengesetzten Seiten begrenzen, und die Vertiefung 17 erstreckt sich in dieser Oberfläche 14 von einer dieser beiden Endflächen 19 quer über den ganzen Schichtenstapel 1 bis zur anderen Endfläche 19.

Beispielsweise bildet die Vertiefung 17 einen länglichen Graben, der sich sich parallel zur Ebene 100 der Schichten in einer Längsrichtung r1 zwischen den Endflächen 19 erstreckt, die in den Figuren 1, 3 und 4 senkrecht zur Zeichenebene ist. Diese Figuren zeigen eine zur Oberfläche 24 senkrechte und zur Zeichenebene parallele Seitenfläche 26 des Trägerkörpers 2 und die Endfläche 19 des Schichtenstapels 1, die in der Figur 2 jeweils unten angeordnet sind.

Beim Ausführungsbeispiel nach den Figuren 1, 2 und 4 ist die Vertiefung 17 vorzugsweise über einer Lücke 17' zwischen den voneinander getrennten Kontakten 21 und 22 des Trägerkörpers 2 angeordnet, so daß sich diese Kontakte 21 und 22 und entsprechend die Kontakte 15 und 160 des Schichtenstapels 1 auf einander gegenüberliegenden Seiten der Vertiefung 17 befinden. Im Fall der Vertiefung 17 in Form des sich in der Richtung r1 erstreckenden Grabens erstreckt sich diese Lücke 17 ebenfalls in dieser Richtung r1.

Eine an der dem Trägerkörper 2 zugekehrten Oberfläche 14 des Schichtenstapels 1 ausgebildete Reflektoreinrichtung 4 zum Reflektieren von im Schichtenstapel 4 erzeugten und auf diese Fläche 4 treffenden Photonen zurück in den Schichtenstapel 4 besteht beispielsweise aus dem Halbleiterkontakt 15, der auf der dem Trägerkörper 2 zugekehrten Oberfläche 14 des Schichtenstapels 1 ausgebildet ist und der reflektierend wirkt, d.h. seine dem Schichtenstapel 1 zugekehrte Flachseite 150 ist eine spiegelnde Fläche. Dieser Kontakt 15 sollte die dem Trägerkörper 2 zugekehrte Oberfläche 14 des Schichtenstapels 1 möglichst großflächig abdecken, damit möglichst viel Photonen reflektiert und möglichst wenig verlorengehen.

Eine Einrichtung 6 zur Erleichterung eines Austritts von im Schichtenstapel 1 erzeugten Photonen aus dem Schichtenstapel 1 weist schräg in einem Winkel relativ zueinander angeordnete Oberflächenabschnitte auf, die beispielsweise aus schräg in einem Winkel α zur Ebene der Schichten 100 angeordneten Endflächen 18, 18 des Schichtenstapels 1, senkrecht zur Ebene 100 der Schichten angeordneten seitlichen Wandflächen 171, 171 der Vertiefung 17 und in der Ebene 100 der Schichten schräg in einem Winkel β zueinander verlaufenden und schräg oder senkrecht zur Ebene 100 der Schichten angeordneten Endflächen 19, 19 des Schichtenstapels 1 bestehen und jeweils paarweise einander zugeordnet je zwei schräg in einem Winkel relativ zueinander angeordnete Oberflächenabschnitte bilden.

Dies ist jedoch nur ein spezielles Beispiel, die Endflächen 18, 18, 19, 19 und Wandflächen 171, 171 können in jeder anderen Art und Weise schräg in einem Winkel relativ zueinander angeordnet sein. Jedenfalls sollten jeweils zwei voneinander abgekehrte Oberflächenabschnitte - Endflächen und/oder Wandflächen - schräg in einem Winkel zueinander stehen. Letzteres ist gewährleistet, wenn von zwei voneinander abgekehrten Oberflächenabschnitten wenigstens einer schräg in einem Winkel und der andere in einem zu diesem Winkel verschiedenen Winkel schräg zur Ebene 100 der Schichten angeordnet ist.

Außerdem weist die Einrichtung 6 zur Erleichterung des Austritts von Photonen ein auf der Oberfläche des Schichtenstapels 1 ausgebildetes fein strukturiertes Relief 61 auf.

Unter Oberfläche des Schichtenstapels 1 ist dessen gesamte Oberfläche zu verstehen, die aus der dem Trägerkörper 2 zugekehrten Oberfläche 14, der vom Trägerkörper 2 abgekehrten Oberfläche 14' und allen sonstigen Oberflächenabschnitten 18, 19, 170, 171 besteht. Das Relief 61 kann auf jedem dieser Oberflächenabschnitte 18, 19, 170, 171 ausgebildet sein, sollte aber wie in der Figur 2 bruchstückhaft angedeutet zumindest auf der vom Trägerkörper 2 abgekehrten Oberfläche 14' vorgesehen sein.

Der Winkel α, in welchem eine Endfläche 18, 19 schräg zur Ebene 100 der Schichten angeordnet ist, beträgt vorzugsweise weniger als 30° bei unvergossenen und weniger als 40° bei vergossenen erfindungsgemäßen Lichtquellen, wobei die Richtung der Neigung beliebig ist. Auch eine Wandfläche 171 der Vertiefung 17 kann in schräg in einem solchen Winkel α zur Ebene 100 der Schichten geneigt angeordnet sein.

Wenn der Schichtenstapel 1 aus III-V-Halbleitermaterial und der Trägerkörper 2 aus Silizium besteht, haben beide einen hinreichend ähnlichen thermischen Ausdehnungskoeffizienten und der Trägerkörper 2 ist ausreichend gut wärmeleitend.

Der Trägerkörper 2 kann aus elektrisch isolierendem Material, beispielsweise undotiertem oder semiisolierendem Halbleitermaterial wie Silizium, oder aus elektrisch leitendem Material, beispielsweise leitendes Halbleitermaterial wie Silizium oder Metall, bestehen.

Im Fall des Ausführungsbeispiels nach den Figuren 1, 2 und 4 müssen bei leitendem Trägerkörper 2 sämtliche elektrisch voneinander getrennten Kontakte 21 und 22 des Trägerkörpers 2 von diesem elektrisch isoliert sein.

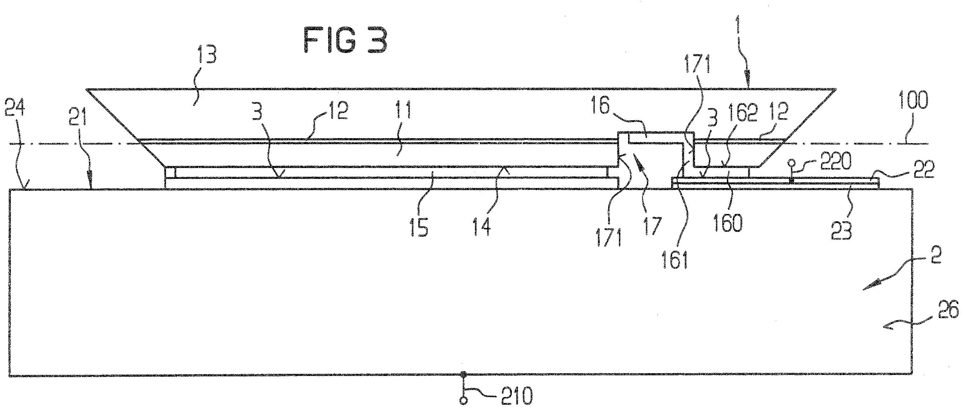

In der Figur 3 ist ein modifiziertes Ausführungsbeispiel mit einem Trägerkörper 2 aus elektrisch leitendem Material dargestellt, das sich vom Beispiel nach den Figuren 1, 2 und 4 dadurch unterscheidet, daß einer der Kontakte 21 und 22 des Trägerkörpers 2, beispielsweise der Kontakt 22, vom Trägerkörper 2 elektrisch isoliert und der elektrisch von diesem Kontakt 22 getrennte andere Kontakt 21 durch das Material des Trägerkörpers 2 selbst gebildet ist. In der Figur 3 sind Teile, die mit Teilen des Ausführungsbeispiels nach den Figuren 1 und 2 übereinstimmen, mit gleichen Bezugszeichen bezeichnet.

Beim Beispiel nach Figur 3 ist der Kontakt 22 des Trägerkörpers 2 durch eine elektrisch isolierende Schicht 23, beispielsweise eine Klebstoffschicht, von der Oberfläche 24 des Trägerkörpers 2 isoliert und durch ein elektrisch leitendes Vebindungsmittel 3, beispielsweise Lot oder elektrisch leitender Klebstoff, mit dem anderen Kontakt 160 des Schichtenstapels 1 verbunden. Der Kontakt 21 des Trägerkörpers 2 ist durch dessen Oberfläche 24 selbst gebildet und durch ein elektrisch leitendes Vebindungsmittel 3, beispielsweise Lot oder elektrisch leitender Klebstoff, direkt mit dem Halbleiterkontakt 15 des Schichtenstapels 1 verbunden.

Anders als beim Beispiel nach den Figuren 1, 2 und 4, bei dem jeder der elektrisch voneinander getrennten Kontakte 21 und 22 des Trägerkörpers 2 auf dessen dem Schichtenstapel 1 zugekehrten Oberfläche 24 mit je einem äußeren Anschlußkontakt 210 bzw. 220, beispielsweise ein Bonddraht, versehen ist, ist beim Beispiel nach Figur 3 der der vom Trägerkörper 2 elektrisch isolierte Kontakt 22 auf der Oberfläche 24 mit einem äußeren Anschlußkontakt 220 und eine von dieser Oberfläche 24 und damit vom Schichtenstapel 1 abgekehrte Oberfläche 25 des Trägerkörpers 2 mit einem äußeren Anschlußkontakt 210 versehen, so daß in diesem Fall die Halbleiterlichtquelle von der Rückseite des Trägerkörpers 2 und durch diesen hindurch von außen kontaktiert ist.

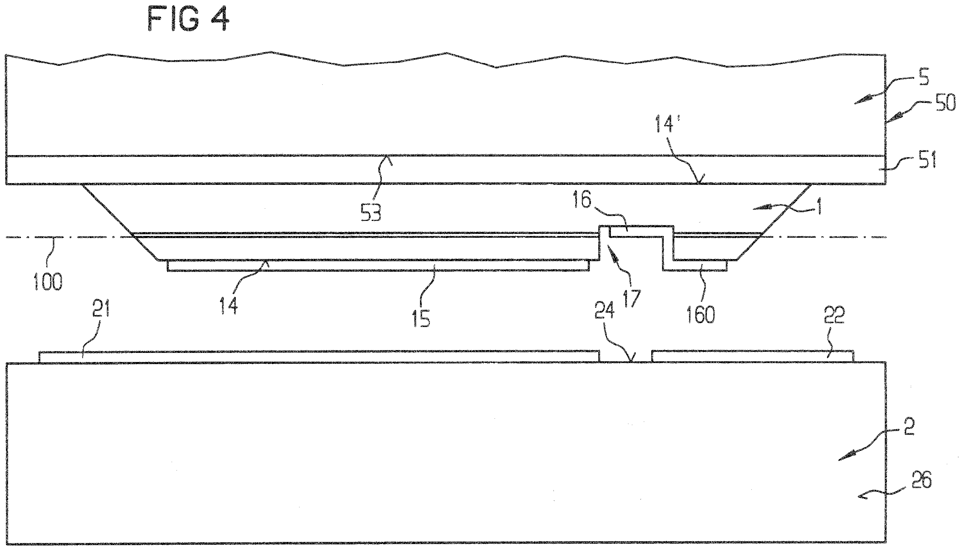

Die Herstellung der erfindungsgemäßen Halbleiterlichtquelle erfolgt unter Bezugnahme auf die Figur 4 so, daß auf einem Wachstumssubstrat 5 epitaktisch der für die Lichtquelle bestimmte Schichtenstapel 1 gewachsen wird, der mit dem Wachstumssubstrat 5 verbundene Schichtenstapel 1 auf dem die elektrisch voneinander getrennten Kontakte 21, 22 aufweisenden Trägerkörper 2 angeordnet und mit dem Verbindungsmittel 3 befestigt wird und danach der derart auf dem Trägerkörper 2 befestigte Schichtenstapel 1 vom Wachstumssubstrat 5 getrennt wird.

Demnach ist die dem Trägerkörper 2 zugekehrte Oberfläche 14 des Schichtenstapels 1 die vom Wachstumssubstrat 5 abgekehrte freie Oberfläche des Schichtenstapels 1, die vor der Trennung des Schichtenstapels 1 vom Wachstumssubstrat 5 strukturiert und kontaktiert, z.B. mit der Vertiefung 17 und den Kontakten 15, 16 und 160 einschließlich der Verbindungsleitung 161 versehen wird.

In der Figur 4 ist ein Trägerkörper 2 nach den Figuren 1 und 2 angenommen, es könnte ebensogut ein Trägerkörper 2 nach Figur 3 verwendet werden.

Zum Trennen des Schichtenstapels 1 vom Wachstumssubstrat 5 wird zweckmäßigerweise so vorgegangen, daß vor dem epitaktischen Wachsen der Schichten des Schichtenstapels 1 auf dem Wachstumssubstrat 5 epitaktisch eine Zwischenschicht 51 aus einem Material gewachsen wird, das mit einem selektiv wirkenden Ätzmittel ätzbar ist, welches das Material jeder epitaktisch zu wachsenden Schicht des Schichtenstapels 1, im Beispiel jeder der Schichten 11, 12 und 13, nicht oder weniger stark angreift, als das Material der Zwischenschicht 51, daß auf der Zwischenschicht 51 epitaktisch die Schichten des Schichtenstapels 1 gewachsen werden und daß zum Trennen des Schichtenstapels 1 vom Wachstumssubstrat 5 die Zwischenschicht 51 mit dem selektiv wirkenden Ätzmittel geätzt wird.

Beispielsweise werden ein Wachstumssubstrat 5 aus GaAs, ein Schichtenstapel 1 auf der Basis von InGaAlAs, eine Zwischenschicht 51 aus AlAs und ein flußsäurehaltiges Ätzmittel verwendet.

Bei der Herstellung der erfindungsgemäßen Halbleiterlichtquellen wird vorteilhafterweise so vorgegangen, daß mehrere Schichtenstapel 1 im Waferverbund als Inseln oder Meseten 50 im Raster mehrerer Trägerkörper 2 präpariert werden, wobei die Form der Grundfläche jedes Schichtenstapels 1 beliebig wählbar ist, vorzugsweise mit spitzwinklig zueinander angeordneten seitlichen Endflächen 19. In der Figur 4 ist eine einzelne Insel 50 gezeigt, die sich von einer Grundfläche 52 eines bruchstückhaft dargestellten Wafers erhebt, der das Wachstumssubstrat 5 insgesamt bildet. Die Zwischenschicht 51 ist auf die erhabene Oberfläche 53 der Insel oder des Mesa 50 angeordnet.

Zur Bildung der Meseten oder Inseln 50 wird vorzugsweise so vorgegangen, daß auf die Oberfläche des Wafers die Zwischenschicht 51 und die Schichten des Schichtenstapels 1 ganzflächig epitaktisch aufgewachsen und danach aus der beschichteten Oberfläche die Inseln 50 herausgeätzt werden.

## Patentansprüche

1. Halbleiterlichtquelle mit einem aus epitaktisch aufeinander gewachsenen Schichten (11, 12, 13) aus Halbleitermaterial bestehenden Schichtenstapel (1) zur Erzeugung und Abstrahlung von Photonen als optische Leistung der Lichtquelle, wobei
- der Schichtenstapel (1) Schichten aus Halbleitermaterial voneinander verschiedenen Leitfähigkeitstyps (p, n) aufweist, zwischen denen ein optisch aktiver Übergang von einem ersten (p; n) zu einem zweiten Leitfähigkeitstyp (n; p) zur Erzeugung der Photonen ausgebildet ist,
- der Schichtenstapel (1) in einer zu einer Ebene (100) der Schichten (11, 12, 13) im Wesentlichen parallelen Oberfläche (14) eine Vertiefung (17) aufweist, die sich von dieser Oberfläche (14) aus in Richtung senkrecht zur Ebene (100) der Schichten (11, 12, 13) durch einen Übergang von Halbleitermaterial des ersten Leitfähigkeitstyps (p, n) zu Halbleitermaterial des zweiten Leitfähigkeitstyps (n, p) des Schichtenstapels (1) hindurch erstreckt,
- auf der Oberfläche (14) des Schichtenstapels (1), in der die Vertiefung (17) ausgebildet ist, ein Halbleiterkontakt (15) für den ersten Leitfähigkeitstyp (p, n) und ein anderer Kontakt (160) für den zweiten Leitfähigkeitstyp (n, p) angeordnet sind, und
- in der Vertiefung (17) ein weiterer Halbleiterkontakt (16) angeordnet ist, der das Halbleitermaterial des zweiten Leitfähigkeitstyps (n, p) unmittelbar kontaktiert und der elektrisch mit dem anderen Kontakt (160) des Schichtenstapels (1) verbunden ist, **dadurch gekennzeichnet, dass**
- der Schichtenstapel (1) frei ist von einem Wachstumssubstrat und eine Gesamtdicke (d) von höchstens 50 µm aufweist,
- der Schichtenstapel (1) an einem gesonderten Trägerkörper (2) angeordnet ist und mittels eines gesonderten Verbindungsmittels (3) mit dem Trägerkörper (2) verbunden ist,
- der Trägerkörper (2) einen elektrischen Kontakt (21) und einen elektrisch von diesem einen Kontakt (21) getrennten anderen elektrischen Kontakt (22) aufweist,
- der Halbleiterkontakt (15) an den einen elektrischen Kontakt (21) des Trägerkörpers (2) und der andere Kontakt (160) des Schichtenstapels (1) an den anderen elektrischen Kontakt (22) des Trägerkörpers (2) angeschlossen sind, und
- der Schichtenstapel (1) voneinander abgekehrte und schräg in einem Winkel zur Ebene (100) der Schichten (11, 12, 13) stehende Endflächen (19) aufweist, welche die Oberfläche (14) des Schichtenstapels (1), in der die Vertiefung (17) ausgebildet ist, auf zueinander entgegengesetzten Seiten begrenzen, und sich die Vertiefung (17) in dieser Oberfläche (14) von einer Endfläche (19) bis zur anderen Endfläche (19) erstreckt.

2. Halbleiterlichtquelle gemäß Anspruch 1, wobei der Halbleiterkontakt (15) unmittelbar auf dem einen elektrischen Kontakt (21) des Trägerkörpers (2) und der andere Kontakt (160) des Schichtenstapels unmittelbar auf dem anderen elektrischen Kontakt (22) des Trägerkörpers (2) aufliegen.

3. Lichtquelle nach einem der obigen Ansprüche, wobei die Oberfläche (14) des Schichtenstapels (1), in der die Vertiefung (17) ausgebildet ist, dem Trägerkörper (2) zugekehrt ist.

4. Halbleiterlichtquelle nach einem der obigen Ansprüche, wobei der weitere Halbleiterkontakt (16) ein ohmscher Kontakt ist.

5. Halbleiterlichtquelle nach dem vorherigen Anspruch, wobei der weitere Halbleiterkontakt (16) über eine elektrische Verbindungsleitung (161) mit dem anderen Kontakt (160) des Schichtenstapels (1) elektrisch verbunden ist.

6. Halbleiterlichtquelle nach dem vorherigen Anspruch, wobei die elektrische Verbindungsleitung (161) und der andere Kontakt (160) des Schichtenstapels (1) aus dem gleichen Material wie der weitere Halbleiterkontakt (16) bestehen.

7. Halbleiterlichtquelle nach eine der Ansprüche 5 oder 6, wobei
die elektrische Verbindungsleitung (161) auf einer seitlichen Wandfläche der Vertiefung (17) angeordnet ist.

8. Halbleiterlichtquelle gemäß einem der Ansprüche 5 bis 7, wobei
die elektrische Verbindungsleitung (161) und der andere Kontakt (160) elektrisch vom Halbleitermaterial des Schichtenstapels (1) getrennt sind.

9. Halbleiterlichtquelle nach dem vorherigen Anspruch, wobei eine elektrisch isolierende Klebstoffschicht (162) zwischen dem Halbleitermaterial des Schichtenstapels (1), der Verbindungsleitung (161) und dem anderen Kontakt (160) angeordnet ist.

10. Halbleiterlichtquelle nach einem der vorherigen Ansprüche, wobei
die Vertiefung (17) einen länglichen Graben bildet, der sich parallel zur Ebene (100) der Schichten (11, 12, 13) in einer Längsrichtung (r1) zwischen den Endflächen (19) erstreckt.

11. Halbleiterlichtquelle gemäß einem der vorhergehenden Ansprüche, wobei auf einer vom Trägerkörper (2) abgewandten Oberfläche des Schichtenstapels (1) ein fein strukturiertes Relief (61) ausgebildet ist.

12. Halbleiterlichtquelle gemäß einem der vorhergehenden Ansprüche, wobei
an einer dem Trägerkörper (2) zugekehrten Oberfläche (14) des Schichtenstapels (1) eine Reflektoreinrichtung (4) zum Reflektieren von im Schichtenstapel (1) erzeugten und auf diese Fläche (14) treffenden Photonen zurück in den Schichtenstapel (1) ausgebildet ist.

## Claims

1. Semiconductor light source having a layer stack (1), consisting of layers (11, 12, 13) of semiconductor material that are epitaxially grown one on the other, for producing and emitting photons as the optical performance of the light source, wherein
- the layer stack (1) has layers of semiconductor material of mutually different conductivity type (p, n), between which is formed an optically active transition from a first conductivity type (p; n) to a second conductivity type (n; p) for producing the photons,
- the layer stack (1) has, in a surface (14) that is substantially parallel to a plane (100) of the layers (11, 12, 13), a depression (17) that extends from this surface (14) in a direction perpendicular to the plane (100) of the layers (11, 12, 13) through a transition of semiconductor material of the first conductivity type (p, n) to semiconductor material of the second conductivity type (n, p) of the layer stack (1),
- a semiconductor contact (15) for the first conductivity type (p, n) and another contact (160) for the second conductivity type (n, p) are arranged on the surface (14) of the layer stack (1), in which the depression (17) is formed, and
- a further semiconductor contact (16) is arranged in the depression (17), which directly makes contact with the semiconductor material of the second conductivity type (n, p) and is electrically connected to the other contact (160) of the layer stack (1), **characterized in that**
- the layer stack (1) is free from a growth substrate and has a total thickness (d) of at most 50 µm,
- the layer stack (1) is arranged on a separate carrier body (2) and is connected to the carrier body (2) by way of a separate connection means (3),
- the carrier body (2) has one electrical contact (21) and another electrical contact (22), which is electrically isolated from said one contact (21),
- the semiconductor contact (15) is connected to the one electrical contact (21) of the carrier body (2), and the other contact (160) of the layer stack (1) is connected to the other electrical contact (22) of the carrier body (2), and
- the layer stack (1) has end faces (19) that face away from one another, are at an angle with respect to the plane (100) of the layers (11, 12, 13) and delimit the surface (14) of the layer stack (1), in which the depression (17) is formed, on mutually opposite sides, and the depression (17) in this surface (14) extends from one end face (19) to the other end face (19).

2. Semiconductor light source according to Claim 1, wherein the semiconductor contact (15) rests immediately on the one electrical contact (21) of the carrier body (2) and the other contact (160) of the layer stack rests immediately on the other electrical contact (22) of the carrier body (2).

3. Light source according to one of the above claims, wherein the surface (14) of the layer stack (1), in which the depression (17) is formed, faces the carrier body (2).

4. Semiconductor light source according to one of the above claims, wherein the further semiconductor contact (16) is an ohmic contact.

5. Semiconductor light source according to the preceding claim, wherein the further semiconductor contact (16) is electrically connected to the other contact (160) of the layer stack (1) by way of an electrical connection line (161).

6. Semiconductor light source according to the preceding claim, wherein the electrical connection line (161) and the other contact (160) of the layer stack (1) are made of the same material as the further semiconductor contact (16).

7. Semiconductor light source according to one of Claims 5 or 6, wherein the electrical connection line (161) is arranged on a lateral wall face of the depression (17).

8. Semiconductor light source according to one of Claims 5 to 7, wherein the electrical connection line (161) and the other contact (160) are electrically isolated from the semiconductor material of the layer stack (1).

9. Semiconductor light source according to the preceding claim, wherein an electrically insulating adhesive layer (162) is arranged between the semiconductor material of the layer stack (1), the connection line (161) and the other contact (160).

10. Semiconductor light source according to one of the preceding claims, wherein the depression (17) forms an elongate trench that extends in a longitudinal direction (r1) between the end faces (19) parallel to the plane (100) of the layers (11, 12, 13).

11. Semiconductor light source according to one of the preceding claims, wherein a finely structured relief (61) is formed on a surface of the layer stack (1) that faces away from the carrier body (2).

12. Semiconductor light source according to one of the preceding claims, wherein a reflector device (4) for reflecting photons, which are generated in the layer stack (1) and are incident on a surface (14) of the layer stack (1) that faces the carrier body (2), back into the layer stack (1) is formed on said surface (14).

## Revendications

1. Source de lumière à semi-conducteur comportant un empilement de couches (1) en matériau semi-conducteur constitué de couches (11, 12, 13) formées les unes sur les autres par croissance épitaxiale pour produire et émettre des photons en tant que puissance optique de la source de lumière, dans lequel
- l'empilement de couches (1) comporte des couches de matériau semi-conducteur ayant des types de conductivité (p, n) différents les uns des autres, entre lesquelles est réalisée une transition optiquement active d'un premier (p ; n) à un deuxième type de conductivité (n ; p) afin de produire les photons,
- l'empilement de couches (1) présente, dans une surface (14) sensiblement parallèle à un plan (100) des couches (11, 12, 13), un creux (17) qui s'étend depuis ladite surface (14), dans une direction perpendiculaire au plan (100) des couches (11, 12, 13), à travers une transition du matériau semi-conducteur du premier type de conductivité (p, n) au matériau semi-conducteur du deuxième type de conductivité (n, p) de l'empilement de couches (1),
- un contact semi-conducteur (15) destiné au premier type de conductivité (p, n) et un autre contact (160) destiné au deuxième type de conductivité (n, p) sont disposés sur la surface (14) de l'empilement de couches (1) dans lequel est formé le creux (17), et
- un contact semi-conducteur supplémentaire (16) est disposé dans le creux (17), lequel autre contact est directement en contact avec le matériau semi-conducteur du deuxième type de conductivité (n, p) et est électriquement relié à l'autre contact (160) de l'empilement de couches (1), **caractérisé en ce que**
- l'empilement de couches (1) est dépourvu d'un substrat de croissance et présente une épaisseur totale (d) d'au plus 50 µm,
- l'empilement de couches (1) est disposé sur un corps de support séparé (2) et est relié au corps de support (2) par un moyen de liaison (3) séparé,
- le corps de support (2) comporte un contact électrique (21) et un autre contact électrique (22) électriquement séparé dudit contact (21),
- le contact semi-conducteur (15) est connecté audit un contact électrique (21) du corps de support (2) et l'autre contact (160) de l'empilement de couches (1) est connecté à l'autre contact électrique (22) du corps de support (2),
- l'empilement de couches (1) comporte des surfaces d'extrémité (19) tournées dans des sens opposés et en biais l'une par rapport à l'autre en formant un angle par rapport au plan (100) des couches (11, 12, 13), lesquelles surfaces d'extrémité délimitent sur des côtés opposés la surface (14) de l'empilement de couches (1) dans lequel est formé le creux (17) et le creux (17) s'étend dans ladite surface (14) d'une surface d'extrémité (19) à l'autre surface d'extrémité (19).

2. Source de lumière à semi-conducteur selon la revendication 1, dans laquelle le contact semi-conducteur (15) repose directement sur ledit contact électrique (21) du corps de support (2) et l'autre contact (160) de l'empilement de couches repose directement sur l'autre contact électrique (22) du corps de support (2).

3. Source de lumière selon l'une des revendications précédentes, dans laquelle la surface (14) de l'empilement de couches (1) dans laquelle le creux (17) est formé est tournée vers le corps de support (2).

4. Source de lumière à semi-conducteur selon l'une des revendications précédentes, dans laquelle le contact semi-conducteur supplémentaire (16) est un contact ohmique.

5. Source de lumière à semi-conducteur selon l'une des revendications précédentes, dans laquelle le contact semi-conducteur supplémentaire (16) est électriquement relié à l'autre contact (160) de l'empilement de couches (1) par l'intermédiaire d'une ligne de liaison électrique (161).

6. Source de lumière à semi-conducteur selon la revendication précédente, dans laquelle la ligne de liaison électrique (161) et l'autre contact (160) de l'empilement de couches (1) sont constitués du même matériau que le contact semi-conducteur supplémentaire (16).

7. Source de lumière à semi-conducteur selon l'une des revendications 5 ou 6, dans laquelle la ligne de liaison électrique (161) est disposée sur une surface de la paroi latérale du creux (17).

8. Source de lumière à semi-conducteur selon l'une des revendications 5 à 7, dans laquelle la ligne de liaison électrique (161) est électriquement séparée du matériau semi-conducteur de l'empilement de couches (1).

9. Source de lumière à semi-conducteur selon la revendication précédente, dans laquelle une couche d'adhésif (162) électriquement isolante est disposée entre le matériau semi-conducteur de l'empilement de couches (1), la ligne de liaison électrique (161) et l'autre contact (160).

10. Source de lumière à semi-conducteur selon l'une des revendications précédentes, dans laquelle le creux (17) forme une tranchée longitudinale qui s'étend parallèlement au plan (100) des couches (11, 12, 13) dans une direction longitudinale (r1) entre les surfaces d'extrémité (19).

11. Source de lumière à semi-conducteur selon l'une des revendications précédentes, dans laquelle un relief finement structuré (61) est formé sur une surface de l'empilement de couches (1) qui est tournée en sens opposé à l'empilement de couches (1).

12. Source de lumière à semi-conducteur selon l'une des revendications précédentes, dans laquelle un dispositif réflecteur (4) destiné à réfléchir des photons produits dans l'empilement de couches (1), apparaissant sur ladite surface (14) et renvoyés dans l'empilement de couches (1), est formé sur une surface (14) de l'empilement de couches (1) qui est tournée vers le corps de support (2).
